# EUROPEAN PATENT SPECIFICATION

(11) **EP 2 963 510 B1**
(45) Date of publication and mention of the grant of the patent: **18.11.2020**
(21) Application number: 13876412.1
(22) Date of filing: 02.12.2013
(51) Int. Cl.: G05B 19/04, H01H 47/00, H03K 17/28

(54) **CONTROL CIRCUIT OF TIME RELAY**
STEUERSCHALTUNG FÜR ZEITRELAIS
CIRCUIT DE COMMANDE D'UN RELAIS TEMPOREL

(30) Priority: 01.03.2013 CN 201310066648
(43) Date of publication of application: 06.01.2016
(73) Proprietor: Zhejiang Chint Electrics Co., Ltd., Yueqing, Zhejiang 325603 (CN)
(72) Inventor: YU, Xuefeng, Yueqing Zhejiang 325603 (CN); SU, Min, Yueqing Zhejiang 325603 (CN); ZHENG, Guangshu, Yueqing Zhejiang 325603 (CN)
(74) Representative: Petraz, Gilberto Luigi
(86) International application number: PCT/CN2013/088293
(87) International publication number: WO 2014/131296

(56) References cited:
- CN-A- 103 149 852
- CN-U- 201 533 164
- CN-U- 201 716 328
- CN-U- 201 732 260
- CN-U- 203 287 705
- CN-Y- 201 274 463
- US-A- 3 622 811
- US-A- 3 688 130
- US-A- 3 769 529
- US-A1- 2003 233 429

## Description

### Technical Field

The present invention relates to a control circuit of a timing relay, and particularly, to a control circuit of a timing relay allowing using a switch which disconnects a weak on-state element connected in parallel among contacts as a trigger apparatus.

US 3 622 811 discloses a timing control circuit.

### Background Art

A timing relay is widely applied to various fields as a control circuit apparatus, which includes a control circuit configured to control the on-off of an output loop thereof, wherein the control circuit includes a power circuit, a triggering signal processing circuit, a timing/time-delay circuit and an electromagnetic relay output circuit. The power circuit is configured to supply power for the control circuit, the triggering signal processing circuit is configured to control the on-off state conversion of the output loop of the output circuit, and the timing/time-delay circuit is configured to control the timing and/or slow-action of the on-off state conversion of the output loop of the output circuit. An output terminal of the output circuit is connected in series in the output loop of the output circuit; meanwhile, the output terminal is configured to be connected to a control switch or a trigger apparatus in a controlled load circuit or a load control circuit, for directly controlling the on/off of the load circuit. The timing relay circuit takes an on/off switch contact as an external trigger apparatus. When the trigger switch is turned on, the relay contact in the output loop of the output circuit is turned on instantaneously for switching the on-off state of the load circuit or the triggering state of the load control circuit. When the a predetermined time arrives, the timing/time-delay circuit issues an instruction to automatically switch off/restore the on-off state of the load circuit or the triggering state of the load control circuit, so as to achieve the object of timing/time-delay control. The simplest triggering signal processing circuit is a triggering switch, which implements to control the on/off state of the output loop of the control circuit of the timing relay through operating the on/off of the trigger switch.

With the rapid development of industrialization today, more and more attentions are paid to Energy savings. Therefore, a timing relay that can automatically switch off the power supply of electric equipments after people leave is gradually accepted by the market. This kind of timing relay needs to be matched with a normally-open push button switch as an external trigger apparatus when in use. When the electric equipment needs to be turned on, the button of switch is pressed, and the timing relay can instantaneously switch on a load circuit and switch off the load circuit according to a preset time delay. Therefore, a weak on-state element which has a on-state current far lower than 100mA needs to be connected in parallel to the trigger switch of a triggering signal processing circuit thereof, for example, a neon tube pilot lamp connected in parallel to the two terminal of the normally-open contact of the switch for displaying the on/off state of the trigger switch, wherein a weak current produced by lightening the pilot lamp (neon tube) enables the timing relay to produce triggering by mistake, so as to disable the time-delay control function of the circuit. At present, in order to expand the use function of the timing relay, people try to selectively add a triggering signal input terminal for being connected in parallel to the external trigger apparatus in the triggering signal processing circuit, while the external trigger apparatus usually has a leakage current as well; that is, there is still a weak current outputted to the output circuit and the timing/time-delay circuit of the timing relay in the state that the external trigger apparatus does not output a triggering signal. However, the control circuit of the existing timing relay does not allow the triggering signal processing circuit to have leakage current or have a larger leakage current (for example, 100mA). This is because that if a leakage current appears, false triggering of the timing relay will be caused on one hand, i.e, the leakage current will also trigger the output circuit and the timing/time-delay circuit of the timing relay to convert the working states even if in the state that the triggering signal processing circuit does not output a triggering signal; and on the other hand, the connection between the trigger apparatus and the timing relay is inconvenient and unsafe, because one terminal of the control loop of the trigger apparatus must be fixed on the pole L (or pole N) of the alternating current power supply. More specifically ,for the timing relay allowing to connect the trigger apparatus to the pole L of the alternating current power supply, it is not allowed to connect the trigger apparatus to the pole N of the alternating current power supply; and for the timing relay allowing to connect the trigger apparatus to the pole N of the alternating current power supply, it is not allowed to connect the trigger apparatus to the pole L of the alternating current power supply.

Therefore, in order to avoid the defect of false triggering by the leakage current, the control circuit of the existing timing relay does not allow to connect the weak on-state element or external trigger apparatus in parallel to the trigger switch, does not allow to connect other elements that can produce a certain current in parallel among the normally-open contacts of the trigger switch matched therewith, or does not allow to externally connect an external trigger apparatus which is not specially used for the timing relay of this model, thus limiting the function and usage expansion and the improvement on the safe use level of the timing relay. If you want to expand the functions of the external trigger unit, then the problem of the control circuit allowing the external trigger apparatus to have a leakage current no more than a rated threshold needs to be solved; meanwhile, with a view to the convenient and safe operation of the external trigger apparatus, the problem of selectively connecting one terminal of the control loop of the external trigger apparatus to the pole L or the pole N of the alternating current power supply needs to be solved as well, i.e., for the same timing relay, one terminal of the control loop of the external trigger apparatus can be freely connected to any one of the pole L or the pole N of the alternating current power supply, so as to satisfy the requirements on the safe power utilization and convenient use of this kind of timing relays on the market.

### Summary of the Invention

The object of the present invention is to provide a control circuit of a timing relay, which overcomes the foregoing multiple defects of the conventional through a structure improvement on a triggering signal processing circuit to enable one terminal of a trigger switch S1 and a weak on-state element connected in parallel to be connected to a live wire terminal L or a ground terminal N of an alternating current power supply, allows to connect the weak on-state element having a leakage current or an external trigger apparatus in parallel among normally-open trigger contacts of a leakage trigger circuit, can implement a leakage current threshold of 100mA, not only is convenient to use and improves the security level, but also expand use functions.

Another object of the present invention is to provide a control circuit of a timing relay, which can be compatible to the access of a remote external trigger apparatus through optionally adding an external trigger terminal X that is connected in parallel to the normally-opened contacts of a leakage trigger circuit, thus expanding the application range of the same kind of timing relays. Through circuit structure optimization and reasonable elements and devices, the control circuit of the timing relay according to the present invention has the advantages of simple structure, good reliability, easy manufacture and low production cost.

In order to achieve the above object, the invention provides the following technical solution about control circuit of a timing relay:
A control circuit of a timing relay, comprising a timing/time-delay circuit D, a relay output circuit F having a first terminal J1 and a second terminal J2, and a step-down rectifier regulator circuit A, the timing/time-delay circuit D comprising a trigger control signal input node (control) and a control output node (out), and the control output node (out) of the timing/time-delay circuit D being connected to the control input terminal of the relay output circuit F. The control circuit further comprises a leakage trigger circuit E and a triggering signal processing circuit B, the leakage trigger circuit E comprises a trigger switch S1, a normally-open trigger contact of the trigger switch S1 is alternatively connected in parallel to a parallel element loop formed by a weak on-state element Y and/or an external trigger terminal X, a node E1 formed by the connection of one terminal of the trigger switch S1, one terminal of the weak on-state element Y and the external trigger terminal X is connected to an input node B1 of the triggering signal processing circuit B, and a node E2 formed by connecting the other terminal of the trigger switch S1 and the other terminal of the weak on-state element Y can be directly connected to any one of the pole L of a live wire terminal or the pole N of a ground terminal at an alternating current input side of the step-down rectifier regulator circuit A; and the leakage trigger circuit E provides a control signal to the triggering signal processing circuit B, and then the triggering signal processing circuit B activates the timing/time-delay circuit D, and then the timing/time-delay circuit D controls the relay output circuit F to implement on-off state conversion of a load; when a current generated by the parallel element loop does not exceed a predetermined current threshold, the timing relay will not be triggered.

Preferably, the triggering signal processing circuit B comprises regulator diodes VD1 and VD2, a photo electric coupler IC1, a field-effect transistor Q1, a triode Q2, diodes D1, D2, D5, D6 and D7, resistors R1-R5, a resistor R11 and capacitors C1-C3, wherein the triggering signal input node B1 is formed by the connection of the negative electrode of the regulator diode VD1, the pole D of the field-effect transistor Q1 and the negative electrode of D1, the positive electrode of the regulator diode VD1 is connected to one terminal of R1, the other terminal of R1 is connected to the positive electrode of the input terminal of the photo electric coupler IC1, the negative electrode of the input terminal of the photo electric coupler IC 1 is connected to the base of the triode Q2 and one terminal of R2, the positive electrode of the output terminal of the photo electric coupler IC1 is connected to VCC, the negative electrode of the output terminal of the photo electric coupler IC1, one terminal of R5 and one terminal of C3 are connected to the trigger control signal input node (control), the other terminal of R5 and the other terminal of C3 are connected to V0, the pole S of the field-effect transistor Q1 is connected to one terminal of R3, the positive electrode of D2 and one terminal of C2, the pole G of the field-effect transistor Q1 is connected to one terminal of C1, the negative electrode of the regulator diode VD2, the negative electrode of D2, the other terminal of C2 and one terminal of R4, the other terminal of R4 is connected to the collector of the triode Q2 and one terminal of R11, the other terminal of R11 is connected to the negative electrode of D7, the positive electrode of D7 is connected to A3, the emitter of the triode Q2 is connected to the other terminal of R2, the positive electrode of the regulator diode VD2, the other terminal of R3, the other terminal of C1, the positive electrode of D6, the positive electrode of D5 and the positive electrode of D1, the negative electrode of D5 is connected to A2, and the negative electrode of D6 is connected to A1.

Preferably, the step-down rectifier regulator circuit A comprises a rectifying circuit A01, a voltage-regulator divider circuit A02 and a non-isolated varying-voltage circuit A03, a live wire terminal L of an alternating current power supply is connected to an alternating current live wire input node AL of the non-isolated varying-voltage circuit A03, a ground terminal N of the alternating current power supply is connected to an alternating current ground input node AN of the non-isolated varying-voltage circuit A03, a live wire output node A1 of the non-isolated varying-voltage circuit A03 and a ground output node A2 of the non-isolated varying-voltage circuit A03 are respectively connected to the two terminals of said alternating current input loop of the rectifying circuit A01, and the voltage-regulator divider circuit A02 is connected in parallel between the direct current output positive electrode A3 of the rectifying circuit A01 and the direct current output earth pole V0 of the rectifying circuit A01, so as to form a public direct current power supply node VCC.

Preferably, the voltage stabilizing values of the regulator diode VD1 and the regulator diode VD2, the resistance values of the resistor R1 and the resistor R2, and the parameter settings of the triode Q2 and the field-effect transistor Q1 shall enable that the pole D and the pole S of Q1 are turned on and VD1 is not turned on when a current I flowing through the triggering signal input node B1 is less than a leakage current threshold, and the pole D and the pole S of Q1 are not turned on and VD1 is turned on when the current I flowing through the triggering signal input node B1 is more than or equal to the leakage current threshold.

One preferred scheme of the relay output circuit F in the present invention is as follows: the relay output circuit F comprises a triode Q3, a triode Q4, a diode D8, a resistor R12, a resistor R13, a resistor R15, a resistor R16, a relay J and a change-over switch S2, the emitter of Q3 is connected to one terminal of R12 and then is connected to A3, the base of Q3 is connected to the other terminal of R12 and one terminal of R13, the other terminal of R13 is connected to a movable contact of S2, one stationary contact of S2 is connected to the collector of Q4, the other stationary contact of S2 is connected to V0, the base of Q4 is connected to one terminal of R15 and one terminal of R16, the emitter of Q4 is connected to the other terminal of R15 and then is connected to V0, the other terminal of R16 is connected to out, the collector of Q3 is connected to the negative electrode of D8 and one terminal of an input loop of the relay J, the other terminal of the input loop of the relay J is connected to the positive electrode of D8 and then is connected to VCC, and the two terminals of a contact loop K1 of the relay J are respectively connected to the first terminal J1 and the second terminal J2.

Another preferred scheme of the relay output circuit F in the present invention is as follows: the relay output circuit F comprises a triode Q3, a triode Q4, a diode D8, a resistor R12, a resistor R13, a resistor R15, a resistor R16, and a relay J, the emitter of Q3 is connected to one terminal of R12 and then is connected to A3, the base of Q3 is connected to the other terminal of R12 and one terminal of R13, the other terminal of R13 is connected to the collector of Q4, the base of Q4 is connected to one terminal of R15 and one terminal of R16, the emitter of Q4 is connected to the other terminal of R15 and then is connected to V0, the other terminal of R16 is connected to out, the collector of Q3 is connected to the negative electrode of D8 and one terminal of an input loop of the relay J, the other terminal of the input loop of the relay J is connected to the positive electrode of D8 and then is connected to VCC, and the two terminals of a contact loop K1 of the relay J are respectively connected to the first terminal J1 and the second terminal J2.

Preferably, the timing/time-delay circuit D comprises a time delay control circuit chip IC2, a diode D3, a diode D4, a resistor R6, a resistor R7, a potentiometer R8, a capacitor C4 and a capacitor C5, the pin 1 of IC2 is connected to VCC, the pin 4 of IC2 is connected to the positive electrode of D3, one terminal of R6 and one terminal of C5, the negative electrode of D3 is connected to the other terminal of R6 and then is connected to VCC, the other terminal of C5 is connected to V0, the pin 5 of IC2 is connected to control, the pin 6 of IC2 is connected to out, the pin 7 and the pin 8, the pin 9 and the pin 14 of IC2 are connected and then are connected to V0, the pin 11 of IC2 is connected to one terminal of R7, and the other terminal of R7 is connected to the positive electrode of D4, one terminal of C4 and the sliding terminal of R8, the negative electrode of D4 is connected to one fixed terminal of R8 and then is connected to VCC, and the other fixed terminal of R8 is connected to V0.

Preferably, the rectifying circuit A01 of said step-down rectifier regulator circuit A comprises a rectifier bridge IC3, a resistor R14 and a capacitor C8, the terminal a of an alternating current input loop of IC3 is connected to A1, the other terminal b of the alternating current input loop of IC3 is connected to one terminal of R14 and one terminal of C8, the other terminal of R14 is connected to the other terminal of C8 and then is connected to A2, the positive electrode c of a direct current output loop of IC3 is a direct current output positive electrode A3, and the negative electrode d of the direct current output loop of IC3 is a direct current output earth pole V0; said voltage-regulator divider circuit A02 comprises a regulator diode VD6, a regulator diode component VDi formed by connection in series of at least one regulator diode VD3, a capacitor C6 and a capacitor C7, the negative electrode of VDi is connected to the positive electrode of C6 and then is connected to A3, a public direct current power supply node VCC is formed by the connection of the positive electrode of VDi, the negative electrode of VD6 and the positive electrode of C7, and the positive electrode of VD6 is connected to the negative electrode of C6, the negative electrode of C7 and V0; and said non-isolated varying-voltage circuit A03 comprises a resistor R9 and a resistor R10, one terminal of R9 is connected to AL, the other terminal of R9 is connected to A1, one terminal of R10 is connected to AN, and the other terminal of R10 is connected to A2.

Preferably, both the voltage stabilizing values of the regulator diode VD1 and the regulator diode VD2 are 24V, both the resistance values of the resistor R1 and the resistor R2 are 100kΩ, the model of the field-effect transistor Q1 is FR420, and a predetermined leakage current threshold is 100mA.

Preferably, the voltage of the direct current output positive electrode A3 of the step-down rectifier regulator circuit A with respect to the direct current output earth pole V0 is any value between 30V and 100V, and the voltage of the public direct current power supply node VCC with respect to the direct current output earth pole V0 is any value between 1.5V and 15V.

The present invention provides a control circuit of a timing relay, which is simple and does not lead to false triggering when a weak current flows through among normally-open contacts of a trigger apparatus. Through optionally equipping parameters of individual elements therein, a leakage current threshold which is greater than 100mA or less than 100mA can be obtained; moreover, other weak on-state elements are allowed being connected in parallel among the normally-open contacts of a push button switch which is accordingly used; when the parallel element loop generates a current which is no more than 100mA, the timing relay will not be triggered, and the foregoing time delay control circuit can still work reliably. Moreover, since one terminal of the trigger switch S1 of the leakage trigger circuit and one terminal of the weak on-state element can be connected to the ground terminal N of the alternating current power supply, when accessing a remote or offsite external trigger apparatus, it only needs to lead out a control wire from the external trigger terminal X of the timing relay, wherein one terminal of a control loop of the trigger apparatus is connected to the control wire, while the other terminal of the control loop of the trigger apparatus can be connected to the ground terminal N of a local alternating current power supply, thus being capable of omitting one control wire between the timing relay and the external trigger apparatus.

### Brief Description of the Drawings

Fig. 1 is a circuit block diagram of a first implementation scheme of a control circuit of a timing relay according to the present invention, wherein a relay output circuit F in Fig. 1 has an option switch S2.
Fig. 2 is a circuit block diagram of a second implementation scheme of a control circuit of a timing relay according to the present invention, wherein a relay output circuit F in Fig. 2 does not have an option switch S2.

### Detailed Description of the Preferred Embodiments

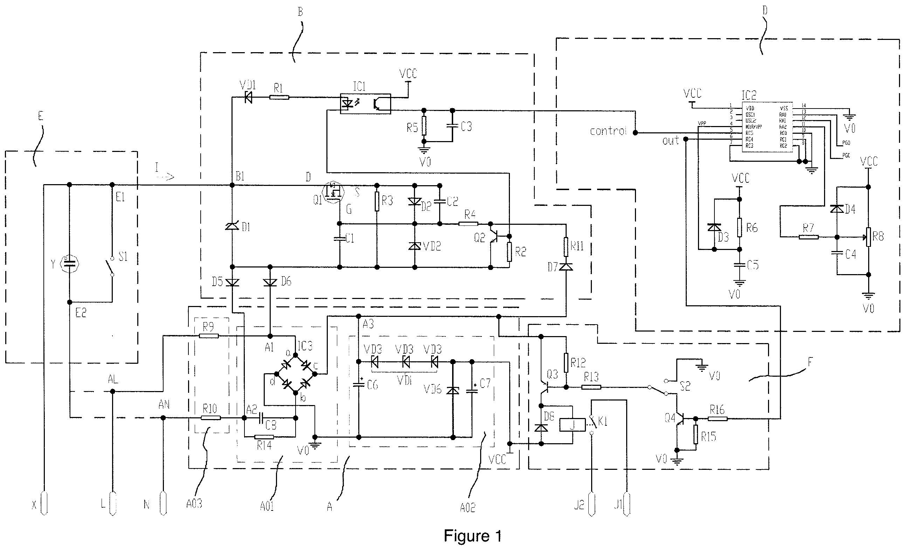

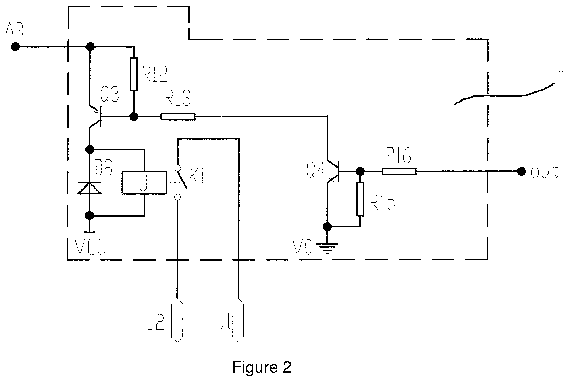

The detailed implementations of a control circuit of a timing relay according to the present invention will be further described in details with reference to Fig. 1 and Fig. 2 as well as given embodiments. Fig. 1 and Fig. 2 are respectively circuit block diagrams of two implementation scheme of a relay output circuit F of the control circuit of the timing relay according to the present invention, wherein the relay output circuit F in Fig. 1 has an option switch S2, while the relay output circuit F in Fig. 2 does not have an option switch S2. The control circuit of the timing relay according to the present invention is not limited to the descriptions in these embodiments.

Referring to Fig. 1, the control circuit of the timing relay according to the present invention includes a timing/time-delay circuit D, a relay output circuit F, a step-down rectifier regulator circuit A, a triggering signal processing circuit B and a leakage trigger circuit E, and further includes a first terminal J1 and a second terminal J2 in the relay output circuit F that are configured to all timing relays for output control, as well as a live wire terminal L and a ground terminal N of an alternating current power supply for providing power to the control circuit of the timing relay. A rated input voltage between the live wire terminal L and the ground terminal N here is the nominal voltage (AC220V, AC240V, AC110V and the like) of the electric grid where the user locates. Products of the foregoing difference voltage specifications can be produced only by adjusting the capacity values of the capacitor C8. The timing/time-delay circuit D includes a trigger control signal input node (control) and a control output node (out), wherein the control output node (out) of the timing/time-delay circuit D is connected to the control input terminal of the relay output circuit F. The control circuit of the present invention further includes a leakage trigger circuit E and a triggering signal processing circuit B. The leakage trigger circuit E includes a trigger switch S1, a normally-open trigger contact of the trigger switch S 1 is alternatively connected in parallel to a parallel element loop formed by a weak on-state element Y and an external trigger terminal X, a node E1 formed by the connection of one terminal of the trigger switch S1, one terminal of the weak on-state element Y and the external trigger terminal X, the node E1 is connected to an input side B1 of the triggering signal processing circuit B, and a node E2 formed by connecting the other terminal of the trigger switch S1 and the other terminal of the weak on-state element Y ,the node E2 can be directly connected to any one of the pole L of a live wire terminal or the pole N of a ground terminal at an alternating current input side of the step-down rectifier regulator circuit A. The circuit of the present timing relay usually employs a control manner that the trigger circuit triggers the timing circuit, and then the timing circuit controls the output of the relay; the trigger circuit cannot identify and process a leakage current signal and a trigger current signal; therefore, false triggering will be produced when a leakage current appears. A control mode employed in the control circuit of the present invention is as follows: the leakage trigger circuit E firstly controls the triggering signal processing circuit B, and then the triggering signal processing circuit B triggers the timing/time-delay circuit D, and then the timing/time-delay circuit D controls the relay output circuit F. There may be multiple implementation schemes for the relay output circuit F according to the present invention, and two schemes are preferred in the present invention, wherein one is a first scheme having the option switch S2 as shown in Fig. 1, and the other is a second scheme not having an option switch S2 as shown in Fig. 2. Referring to Fig. 1, the relay output circuit F of the first scheme includes triodes Q3 and Q4, a diode D8, resistors R12, R13, R15 and R16, a relay J and an option switch S2, wherein the emitter of the triode Q3 is connected to one terminal of R12 and then is connected to A3, the base of the triode Q3 is connected to the other terminal of R12 and one terminal of R13, the other terminal of R13 is connected to a movable contact of S2, one stationary contact of S2 is connected to the collector of the triode Q4, the other stationary contact of S2 is connected to V0, the base of the triode Q4 is connected to one terminal of R15 and one terminal of R16, the emitter of the triode Q4 is connected to the other terminal of R15 and then is connected to V0, the other terminal of R16 is connected to out, the collector of the triode Q3 is connected to the negative electrode of D8 and one terminal of an input loop of the relay J, the other terminal of the input loop of the relay J is connected to the positive electrode of D8 and then is connected to VCC, and the two terminals of a contact loop K1 of the relay J are respectively connected to the first terminal J1 and the second terminal J2 of the relay output circuit F. Referring to Fig. 2, the relay output circuit F of second scheme includes triodes Q3 and Q4, a diode D8, resistors R12, R13, R15 and R16, and a relay J, wherein the emitter of the triode Q3 is connected to one terminal of R12 and then is connected to A3, the base of the triode Q3 is connected to the other terminal of R12 and one terminal of R13, the other terminal of R13 is connected to the collector of the triode Q4, the base of the triode Q4 is connected to one terminal of R15 and one terminal of R16, the emitter of the triode Q4 is connected to the other terminal of R15 and then is connected to V0, the other terminal of R16 is connected to out, the collector of the triode Q3 is connected to the negative electrode of D8 and one terminal of an input loop of the relay J, the other terminal of the input loop of the relay J is connected to the positive electrode of D8 and then is connected to VCC, and the two terminals of a contact loop K1 of the relay J are respectively connected to the first terminal J1 and the second terminal J2 of the relay output circuit F.

Referring to Fig. 1, the triggering signal processing circuit B of the present invention includes regulator diode VD1 and VD2, a photo electric coupler IC1, a field-effect transistor Q1, a triode Q2, diodes D1, D2, D5, D6 and D7, resistors R1, R2, R3, R4, R5 and R11 and capacitors C1, C2 and C3, wherein the triggering signal input node B1 is formed by the connection of the negative electrode of the regulator diode VD1, the pole D of the field-effect transistor Q1 and the negative electrode of the diode D1, the positive electrode of the regulator diode VD1 is connected to one terminal of R1, the other terminal of R1 is connected to the positive electrode of the input terminal of the photo electric coupler IC1, the negative electrode of the input terminal of the photo electric coupler IC1 is connected to the base of the triode Q2 and one terminal of R2, the positive electrode of the output terminal of the photo electric coupler IC1 is connected to VCC, the negative electrode of the output terminal of the photo electric coupler IC1, one terminal of R5 and one terminal of C3 are connected to the trigger control signal input node (control), the other terminal of R5 and the other terminal of C3 are connected to V0, the pole S of the field-effect transistor Q1 is connected to one terminal of R3, the positive electrode of the diode D2 and one terminal of C2, the pole G of the field-effect transistor Q1 is connected to one terminal of C1, the negative electrode of the regulator diode VD2, the negative electrode of the diode D2, the other terminal of C2 and one terminal of R4, the other terminal of R4 is connected to the collector of the triode Q2 and one terminal of R11, the other terminal of R11 is connected to the negative electrode of the diode D7, the positive electrode of the diode D7 is connected to A3, the emitter of the triode Q2 is connected to the other terminal of R2, the positive electrode of the regulator diode VD2, the other terminal of R3, the other terminal of C1, the positive electrode of the diode D6, the positive electrode of the diode D5 and the positive electrode of the diode D1, the negative electrode of the diode D5 is connected to A2, and the negative electrode of the diode D6 is connected to A1. Preferably, both the voltage stabilizing values of the regulator diode VD1 and the regulator diode VD2 of the triggering signal processing circuit B according to the present invention are 24V, both the resistance values of the resistor R1 and the resistor R2 are 100kΩ, the model of the field-effect transistor Q1 is FR420, and a predetermined leakage current threshold is 100mA.

As shown in Fig. 1, the step-down rectifier regulator circuit A of the present invention includes a rectifying circuit A01, a voltage-regulator divider circuit A02 and a non-isolated varying-voltage circuit A03, a live wire terminal L of an alternating current power supply is connected to an alternating current live wire input node AL of the non-isolated varying-voltage circuit A03, a ground terminal N of the alternating current power supply is connected to an alternating current ground input node AN of the non-isolated varying-voltage circuit A03, a live wire output node A1 of the non-isolated varying-voltage circuit A03 and a ground output node A2 of the non-isolated varying-voltage circuit A03 are respectively connected to the two terminals of an alternating current input loop of the rectifying circuit A01, and the voltage-regulator divider circuit A02 is connected in parallel between the direct current output positive electrode A3 of the rectifying circuit A01 and the direct current output earth pole V0 of the rectifying circuit A01, and a public direct current power supply node VCC is obtained by the voltage-regulator divider circuit A02. In the circuit of the present timing relay, an AC-DC converting circuit similar to the rectifying circuit A01 of the present invention is usually used as a direct current power circuit. However, the rectifying circuit A01 of the present invention not only requires the step-down rectifier regulator circuit A to have the AC-DC converting function, but also needs to implement the following functions: when the trigger switch S1 of the leakage trigger circuit E is accessed, the step-down rectifier regulator circuit A can form a non-polar channel; an adaptable public direct current power supply node VCC is obtained between the direct current output positive electrode A3 of the rectifying circuit A01 and the direct current output earth pole V0 of the rectifying circuit A01, wherein the voltage of VCC to V0 is preferably between 1.5V and 15V, and the voltage of A3 to V0 is preferably between 20V and 100V. The AC-DC converting function of the rectifying circuit A01 of the present invention can be implemented via multiple schemes, wherein one preferred scheme of the present invention is as follows: the rectifying circuit A01 includes a rectifier bridge IC3, a resistor r14 and a capacitor C8, wherein the terminal a of an alternating current input loop of IC3 is connected to A1, the other terminal b of the alternating current input loop of IC3 is connected to one terminal of R14 and one terminal of C8, the other terminal of R14 is connected to the other terminal of C8 and then is connected to A2, the positive electrode c of a direct current output loop of IC3 is a direct current output positive electrode A3, and the negative electrode d of the direct current output loop of IC3 is a direct current output earth pole V0. The function of the voltage-regulator divider circuit A02 here is postposition voltage regulation, i.e., acquiring an adaptive public direct current power supply node VCC between the A3 (the positive electrode c of the direct current output loop) of the rectifying circuit A01 and V0 (the negative electrode d), and stabilizing the voltages of A3 and VCC to V0. The voltage-regulator divider circuit A02 may be implemented through multiple schemes, wherein a preferred scheme suitable for the object of the present invention is as follows: the voltage-regulator divider circuit A02 includes a regulator diode VD6, a regulator diode component VDi formed by connection in series of at least one regulator diode VD3, a capacitor C6 and a capacitor C7, wherein the negative electrode of the regulator diode component VDi is connected to the positive electrode of C6 and then is connected to A3, a public direct current power supply node VCC is formed by the connection of the positive electrode of the regulator diode component VDi, the positive electrode of VD6 is connected to the negative electrode of C6, the negative electrode of C7 and V0. The function of the non-isolated varying-voltage circuit A03 is as follows: preposition voltage regulation, wherein an alternating current voltage adaptive to the direct current output positive electrode A3 is obtained between A1 and A2 via preposition voltage regulating; enabling the alternating current live wire input node AL of the non-isolated varying-voltage circuit A03 connected to the live wire terminal L of the alternating current power supply to be communicated with A1, and enabling the alternating current ground input node AN of the non-isolated varying-voltage circuit A03 connected to the ground terminal N of the alternating current power supply to be communicated with A2. The preposition voltage regulation here cannot employ a usual winding type isolation transformer circuit; otherwise, a necessary non-polar passageway cannot be formed. The non-isolated varying-voltage circuit A03 may be implemented through multiple schemes, wherein a preferred scheme suitable for the object of the present invention is as follows: the non-isolated varying-voltage circuit A03 includes a resistor R9 and a resistor R10, wherein one terminal of R9 is connected to AL, the other terminal of R9 is connected to A1, one terminal of R10 is connected to AN, and the other terminal of R10 is connected to A2. It is easy to think of that: the preferred scheme should include the situations when the resistance value of R10 is zero and/or the resistance value of R9 is zero; when the resistance of R9 is zero, there is a lead between A1 and A1; and when the resistance value of R10 is zero, there is a lead between A2 and AN. It is possible that both the resistance of R10 and the resistance of R9 are zero at the same time, wherein this situation actually represents that the preposition voltage regulation ratio of the non-isolated varying-voltage circuit A03 is 1, i.e., the voltage between A1 and A2 is equal to the voltage between AL and AN. It is easy to think of that another scheme that can substitute the preposition voltage regulation scheme is that a voltage regulating resistor (not shown in the Fig.) is added between the direct current output positive electrode A3 and the terminal a of the alternating current input loop of the rectifier bridge IC3, so as to obtain the required voltage value adaptive to A3. The substance of this scheme is to remove R10 or R9 between A3 and a, and the effect thereof is equivalent to that of the given embodiment. The step-down rectifier regulator circuit A of the present invention not only satisfies the requirement of providing adaptive voltages having different forms and voltage classes for the control circuit, but also enables one terminal of the output side of the leakage trigger circuit E to be directly connected to the alternating current input side of the step-down rectifier regulator circuit A in an alternating current single-phase AC220V circuit, and two connection manners are allowed: one manner is to connect one terminal of the output side of the leakage trigger circuit E to line N, and the other manner is to connect one terminal of the output side of the leakage trigger circuit E to line L. One terminal of the control loop of the trigger circuit can be freely connected to any one of the pole L or the pole N of the alternating current power supply, and can both effectively form normal triggering and avoid false triggering no matter one terminal of the control loop is either connected to the pole N or the pole L, and enables the wiring operation of the user on the spot is very convenient and safe.

The embodiment of the leakage trigger circuit E according to the present invention as shown in Fig. 1 includes a trigger switch S1 as well as a weak on-state element Y and/or an external trigger terminal X that can be selectively added, wherein a node E1 formed by the connecting of one terminal of the trigger switch S1 to one terminal of the weak on-state element Y and the external trigger terminal X is connected to B1, and a node E2 formed by the connection of the other terminal of S1 and the other terminal of Y is connected to N or L. The characteristics of the leakage trigger circuit E not only lie in providing for the timing relay a trigger switch S1 for triggering the native machine, but also lie in providing a scheme for connecting an external trigger apparatus and a specific connecting terminal, i.e., the external trigger terminal X. The characteristics of the relay output circuit F not only lie in implement conventional output under the control of the timing/time-delay circuit, but also lie in providing a technical scheme of double control outputs, i.e., the relay output circuit F has two control output manners: one is an output manner under the control of the timing/time-delay circuit D, wherein the time delay control function of the timing relay is implemented under this manner; and the other is an output manner that is not controlled by the timing/time-delay circuit D, wherein the instantaneous on-state function of the timing relay is implemented under this manner; moreover, a technical scheme of capable regulating the timing time and an optional circuit are also provided.

The timing/time-delay circuit D of the present invention employs a monolithic computer chip IC2, wherein the pin 5 of the chip IC2 as shown in Fig. 1 is the trigger control signal input node (control) of the timing/time-delay circuit D, and the pin 6 of the chip IC2 is the control output node (out) of the timing/time-delay circuit D. The control is connected to the triggering signal processing circuit B so as to implement the effect of triggering the timing/time-delay circuit D by the triggering signal processing circuit B. The control input terminal of the relay output circuit F is connected to the control output node (out) of the timing/time-delay circuit D so as to implement the effect of controlling the relay output circuit F by the timing/time-delay circuit D. A software programming manner is employed on the time delay control circuit chip IC2 to implement the foregoing function of the time delay control circuit. The basic function of the timing/time-delay circuit D can be implemented by connecting the IC2 to the power supply thereof. However, in order to improve the performance and expand the use function of the timing/time-delay circuit D, a preferred scheme of the timing/time-delay circuit D of the present invention is as follows: the timing/time-delay circuit D includes a time delay control circuit chip IC2, diodes D3 and D4, resistors R6 and R7, a potentiometer R8 and capacitors C4 and C5, wherein the pin 1 of the time delay control circuit chip IC2 is connected to VCC, the pin 4 of the time delay control circuit chip IC2 is connected to the positive electrode of D3, one terminal of R6 and one terminal of C5, the negative electrode of D3 is connected to the other terminal of R6 and then is connected to VCC, the other terminal of C5 is connected to V0, the pin 5 of the time delay control circuit chip IC2 is connected to "control", the pin 6 of the time delay control circuit chip IC2 is connected to "out", the pin 7 and the pin 8, the pin 9 and the pin 14 of the time delay control circuit chip IC2 are connected and then are connected to V0, the pin 11 of the time delay control circuit chip IC2 is connected to one terminal of R7, and the other terminal of R7 is connected to the positive electrode of D4, one terminal of C4 and the sliding terminal of R8, the negative electrode of D4 is connected to one fixed terminal of R8 and then is connected to VCC, and the other fixed terminal of R8 is connected to V0.

In the five circuits including the step-down rectifier regulator circuit A, the triggering signal processing circuit B, the relay output circuit F, the timing/time-delay circuit D and the leakage trigger circuit E as shown in Fig. 1, the triggering signal processing circuit B is the core. The triggering signal processing circuit B of the present invention forms a fire-new designed circuit through such elements as the field-effect transistor Q1, the triode Q2, the photo electric coupler IC1 and the regulator diodes, which not only has the function of a constant voltage source, but also can identify and process triggering signals according to the leakage current threshold, wherein the working principle thereof is as follows: when a current I conveyed to the triggering signal processing circuit B from the leakage trigger circuit E is less than a leakage current threshold (100mA), the triode Q2 is in an off-state, so that the input voltage of the constant voltage source is at a high potential; at this moment, the field-effect transistor Q1 controlled by the triode Q2 is turned on, so that the current I directly flows into the step-down rectifier regulator circuit A, thus being incapable of forming an effective triggering signal; and when the current I is greater than the leakage current threshold (100mA), the voltage of the base of the triode Q2 is raised and saturated, and the triode Q2 is turned on, so that the input voltage of the constant voltage source is reduced, and the field-effect transistor Q1 controlled by the triode Q2 is cut off to prompt the current I to flow towards the photo electric coupler IC1, so as to turn on the photo electric coupler IC1 and form an effective triggering signal. Due to the elastic working character of the triggering signal processing circuit B of the circuit according to the present invention, the circuit not only can be used for a common switch without a pilot lamp as a trigger switch, but also can be used for a switch having such a weak on-state element as a pilot lamp and connected in parallel to the normally-open contacts; moreover, the present invention allows multiple switches having the foregoing pilot lamps and/or weak on-state element to be used in parallel, and allows an external attached type trigger apparatus (external trigger apparatus). As long as the leakage currents thereof after being accumulated do not exceed the leakage current threshold (100mA), false triggering will not occur to the timing relay.

The working principle of the control circuit of the present invention will be further described with reference to Fig. 1.
1. In the state that the nodes E2 of the leakage trigger circuit E is connected to the live wire terminal L of the alternating current power supply:
   when the trigger switch S1 is cut off, the current I is a leakage current only, and I is no more than a preset leakage current threshold; at this moment, the voltage of a pole G of Q1 is at a high potential, and a pole D and a pole S of the Q1 are turned on. The current I flows back to the pole N of the power supply through Q1, R3, D5 and R10; at this moment, the "control" is at a low potential, the timing/time-delay circuit D and the relay output circuit F are in a standby state, and false triggering will not occur to the timing relay;
   when the trigger switch S1 is turned on, the current I includes a leakage current and a triggering current, and I is greater than the leakage current threshold; at this moment, a loop formed by VD1, R1, IC2 and the resistor R2 starts entering a weak on-state; when the voltage of the resistor R2 divided exceeds the saturated on-state voltage of Q2, Q2 is saturated and turned on; the voltage of the pole G of Q1 is changed to a low potential due to the turning on of Q2, and Q1 is cut off; at this moment, the current I flows through the positive electrodes and negative electrodes of the input terminal of VD1, R1 and IC1, and the resistor R2, D5 and the resistor R10, and then flows back to the pole N of the power supply, and a node at the output terminal of the IC1 connected to the control is at a high potential; therefore, IC2 starts a timing program, and outputs a high level signal from OUT to make the K1 of the electromagnetic relay J closure in the relay output circuit F.
2. In the state that the node E2 of the leakage trigger circuit E is connected to the ground terminal N of the alternating current power supply:
   when the alternating current power supply is in a positive half cycle, the potential of the live wire terminal L is higher than the potential of the ground terminal N; at this moment, no matter the trigger switch S 1 is either in an off or on state, it is not possible that the potential of the node E1 is higher than the potential of the live wire terminal L, and D6 is reversely cut off; therefore, it is not possible for the triggering signal processing circuit B to produce a triggering signal during the positive half cycle, i.e., normal triggering and false triggering are not possible to occur during the positive half cycle;
   when the alternating current power supply is in a negative half cycle, the potential of the ground terminal N is higher than the potential of the live wire terminal L; at this moment, it is possible for the triggering signal processing circuit B to produce a triggering signal; the working principle of the circuit when the trigger switch S1 is in an off/on state is basically the same to that of the situation of being connected to the live wire terminal L, and the difference is that the current I finally flows through D6 (rather than D5) and flows back to the live wire terminal L.

Based on the structures of the foregoing step-down rectifier regulator circuit A, the triggering signal processing circuit B and the leakage trigger circuit E, the present invention, under the premise of not changing the structures of the circuit and through setting the voltage stabilizing values of the regulator diode VD1 and the regulator diode VD2, the resistance values of the resistor R1 and the resistor R2, and the parameters or models of the triode Q2 and the field-effect transistor Q1, can enable that the pole D and the pole S of Q1 are turned on and VD1 is not turned on when the current I flowing through the triggering signal input node B1 is less than the leakage current threshold, and the pole D and the pole S of Q1 are not turned on and VD1 is turned on when the current I flowing through the triggering signal input node B1 is more than or equal to the leakage current threshold. The setting the voltage stabilizing values of the regulator diode VD1 and the regulator diode VD2, the resistance values of the resistor R1 and the resistor R2, and the parameters or models of the triode Q2 and the field-effect transistor Q1 may be implemented through multiple schemes, wherein a preferred scheme is as follows: both the voltage stabilizing values of the regulator diode VD1 and the regulator diode VD2 are 24V, both the resistance values of the resistor R1 and the resistor R2 are 100kΩ, the model of the field-effect transistor Q1 is FR420, and a predetermined leakage current threshold is 100mA. Parameters of the transistor Q2 can be derived from the above mentioned data .It follows that the control circuit of the timing relay according to the present invention solves the foregoing problems that cannot be solved by the prior art, enables the trigger circuit in the control circuit of the timing relay and/or the trigger circuit of the external trigger apparatus to not only allow to use a contact switch, but also allow to use a solid-state switch such a weak on-state element as a pilot lamp and the SCR etc., thus greatly expanding the application field and use function of the timing relay products; and can allow the access of the external trigger apparatus having a leakage current no more than the rated threshold, and provides preconditions for improving the performances and functions of the trigger circuit; for example, in the market ,the leakage current of single trigger circuit having a leakage current is generally 0.5∼5mA, while the control circuit of the present invention can economically implement a 100mA leakage current threshold.

The above-mentioned contents are further descriptions to the present invention with reference to the specific preferred embodiments, and it cannot be deemed that the specific implementation of the present invention are only limited to these descriptions above. For example, the present invention can obtain a leakage current threshold greater than 100mA or less than 100mA through selecting the parameters of some elements in the circuit without changing the structure of the circuit, so that the models and specifications of timing relay products can be conveniently and economically enriched.

The scope of protection of the current invention is defined solely by the claims.

## Claims

1. A control circuit of a timing relay, the control circuit comprising a timing/time-delay circuit D, a relay output circuit F having a first terminal J1 and a second terminal J2, and a step-down rectifier regulator circuit A, the timing/time-delay circuit D is used to implement the time-delay control function of the timing relay, the step-down rectifier regulator circuit A is used to implement AC-DC converting and provide a direct current power supply node VCC, the timing/time-delay circuit D comprising a time delay control circuit chip IC2 provided with a trigger control signal input node (control) and a control output node (out), and the control output node (out) of the timing/time-delay circuit D being connected to a control input terminal of the relay output circuit F, the first terminal J1 and the second terminal J2 of the relay output circuit F being configured to be connected to a control switch or a trigger apparatus in a controlled load circuit or a load control circuit, for directly controlling the on/off of the load circuit; wherein:
the step-down rectifier regulator circuit A comprises a rectifying circuit A01, a voltage-regulator divider circuit A02 and a non-isolated varying-voltage circuit A03, a live wire terminal L of an alternating current power supply is connected to an alternating current live wire input node AL of the non-isolated varying-voltage circuit A03, a ground terminal N of the alternating current power supply is connected to an alternating current ground input node AN of the non-isolated varying-voltage circuit A03, a live wire output node A1 of the non-isolated varying-voltage circuit A03 and a ground output node A2 of the non-isolated varying-voltage circuit A03 are respectively connected to the two terminal of an alternating current input loop of the rectifying circuit A01, and the voltage-regulator divider circuit A02 is connected in parallel between the direct current output positive electrode A3 of the rectifying circuit A01 and the direct current output earth pole V0 of the rectifying circuit A01, so as to form a public direct current power supply node VCC;
the control circuit further comprises a leakage trigger circuit E and a triggering signal processing circuit B, the leakage trigger circuit E comprises a trigger switch S1, a node E1 formed by the connection of one terminal of the trigger switch S1 and one terminal of a weak on-state element Y, or a node E1 formed by the connection of one terminal of the trigger switch S1, one terminal of the weak on-state element Y and an external trigger terminal X; the node E1 being connected to an input node B1 of the triggering signal processing circuit B; and a node E2 formed by the connection of the other terminal of the trigger switch S1 and the other terminal of the weak on-state element Y, the node E2 being connected to any one of the live wire terminal L or the ground terminal N at an alternating current input side of the step-down rectifier regulator circuit A, the leakage trigger circuit E inputting a current I to the triggering signal processing circuit B through the node E1 and the input node B1;
wherein the weak-on state element is an element having an on state current lower than 100 mA such as a pilot lamp;
wherein the external trigger terminal X is for the access of a remote external trigger apparatus, a current signal is given by the remote external trigger apparatus to the circuit B through the external trigger terminal X;
further wherein the current I is the current output by the weak on-state element Y, or the current output by the weak on-state element Y plus the current output by the switch S1, or the current output by the weak on-state element Y plus the current output by the external trigger terminal X, or the current output by the weak on-state element Y plus the current output by the external trigger terminal X plus the current output by the switch S 1;
and further wherein the triggering signal processing circuit B refers to a leakage current, which is taken as the leakage current threshold; the leakage current threshold is used to be compared with current I, such that the numerical size relationship of the current I and the leakage current threshold is determined,
the triggering signal processing circuit B comprises regulator diodes VD1 and VD2, diodes D2, D5 and D6, a photo electric coupler IC1, a field-effect transistor Q1, a triode Q2, resistors R1 and R2; the negative electrode of the regulator diode VD1 and the drain D of the field-effect transistor Q1 are connected to the triggering signal input node B1, the positive electrode of the regulator diode VD1 is connected to the positive electrode of the input terminal of the photo electric coupler IC1 through the resistor R1, the negative electrode of the input terminal of the photo electric coupler IC1 is connected to the base of the triode Q2 and one terminal of resistor R2, the other terminal of resistor R2 is connected to the node A1 via the diode D6, to the node A2 via the diode D5 and to the emitter of the triode Q2, the source S of the field-effect transistor Q1 is connected to the collector of the triode Q2 via the diode D2, to the emitter of the triode Q1, to the node A1 via the diode D6, to the node A2 via the diode D5 and to the negative electrode of the regulator diode VD1, the positive electrode of the regulator diode VD2 is connected to the emitter of the triode Q2, the collector of the triode Q2 is connected to node A3 and to the gate G of the field-effect transistor Q1, the positive electrode of the output terminal of the photo electric coupler IC1 is connected to the node VCC, the negative electrode of the output terminal of the photo electric coupler IC1 is connected to the trigger control signal input node (control);
the leakage trigger circuit E provides the current I to the triggering signal processing circuit B; when the current I does not exceed a leakage current threshold, the drain D and the source S of the field-effect transistor Q1 are turned on and the regulator diode VD1 is not turned on, the timing relay will not be triggered; when the current I is more than the leakage current threshold, the drain D and the source S of the field-effect transistor Q1 are not turned on and the regulator diode VD1 is turned on, then the triggering signal processing circuit B triggers the timing/time delay circuit D through the trigger control signal input node (control), and then the timing/time delay circuit D controls the relay output circuit F to implement on-off state conversion of a load through the control output node (out), and the timing relay will be triggered.

2. The control circuit of the timing relay according to claim 1, **characterized in that**:
the triggering signal processing circuit B further comprises diodes D1 and D7, resistors R3-R5, a resistor R11 and capacitors C1-C3, wherein the negative electrode of the diode D1 is connected to the node B1, the positive electrode of the output terminal of the photo electric coupler IC1 is connected to VCC, the negative electrode of the output terminal of the photo electric coupler IC1, one terminal of R5 and one terminal of C3 are connected to the trigger control signal input node (control), the other terminal of R5 and the other terminal of C3 are connected to V0, the source S of the field-effect transistor Q1 is connected to one terminal of R3, the positive electrode of D2 and one terminal of C2, the gate G of the field-effect transistor Q1 is connected to one terminal of C1, the negative electrode of the regulator diode VD2, the negative electrode of D2, the other terminal of C2 and one terminal of R4, the other terminal of R4 is connected to the collector of the triode Q2 and one terminal of R11, the other terminal of R11 is connected to the negative electrode of D7, the positive electrode of D7 is connected to A3, the emitter of the triode Q2 is connected to the other terminal of R3, the other terminal of C1, the positive electrode of D6, the positive electrode of D5 and the positive electrode of D1, the negative electrode of D5 is connected to A2, and the negative electrode of D6 is connected to A1.

3. The control circuit of the timing relay according to claim 1, **characterized in that**:
the relay output circuit F comprises a triode Q3, a triode Q4, a diode D8, a resistor R12, a resistor R13, a resistor R15, a resistor R16, a relay J and a change-over switch S2, the emitter of Q3 is connected to one terminal of R12 and then is connected to A3, the base of Q3 is connected to the other terminal of R12 and one terminal of R13, the other terminal of R13 is connected to a movable contact of S2, one stationary contact of S2 is connected to the collector of Q4, the other stationary contact of S2 is connected to V0, the base of Q4 is connected to one terminal of R15 and one terminal of R16, the emitter of Q4 is connected to the other terminal of R15 and then is connected to V0, the other terminal of R16 is connected to out, the collector of Q3 is connected to the negative electrode of D8 and one terminal of an input loop of the relay J, the other terminal of the input loop of the relay J is connected to the positive electrode of D8 and then is connected to VCC, and the two terminal of a contact loop K1 of the relay J are respectively connected to the first terminal J1 and the second terminal J2.

4. The control circuit of the timing relay according to claim 1, **characterized in that**:
the relay output circuit F comprises a triode Q3, a triode Q4, a diode D8, a resistor R12, a resistor R13, a resistor R15, a resistor R16, a relay J and a change-over switch S2, the emitter of Q3 is connected to one terminal of R12 and then is connected to A3, the base of Q3 is connected to the other terminal of R12 and one terminal of R13, the other terminal of R13 is connected to the collector of Q4, the base of Q4 is connected to one terminal of R15 and one terminal of R16, the emitter of Q4 is connected to the other terminal of R15 and then is connected to V0, the other terminal of R16 is connected to out, the collector of Q3 is connected to the negative electrode of D8 and one terminal of an input loop of the relay J, the other terminal of the input loop of the relay J is connected to the positive electrode of D8 and then is connected to VCC, and the two terminal of a contact loop K1 of the relay J are respectively connected to the first terminal J1 and the second terminal J2.

5. The control circuit of the timing relay according to claim 1, **characterized in that**:
the timing/time-delay circuit D comprises a diode D3, a diode D4, a resistor R6, a resistor R7, a potentiometer R8, a capacitor C4 and a capacitor C5, the pin 1 of IC2 is connected to VCC, the pin 4 of IC2 is connected to the positive electrode of D3, one terminal of R6 and one terminal of C5, the negative electrode of D3 is connected to the other terminal of R6 and then is connected to VCC, the other terminal of C5 is connected to V0, the pin 5 of IC2 is connected to control, the pin 6 of IC2 is connected to out, the pin 7 and the pin 8, the pin 9 and the pin 14 of IC2 are connected and then are connected to V0, the pin 11 of IC2 is connected to one terminal of R7, and the other terminal of R7 is connected to the positive electrode of D4, one terminal of C4 and the sliding terminal of R8, the negative electrode of D4 is connected to one fixed terminal of R8 and then is connected to VCC, and the other fixed terminal of R8 is connected to V0.

6. The control circuit of the timing relay according to claim 1, **characterized in that**:
the rectifying circuit A01 comprises a rectifier bridge IC3, a resistor R14 and a capacitor C8, the terminal a of an alternating current input loop of IC3 is connected to A1, the other terminal b of the alternating current input loop of IC3 is connected to one terminal of R14 and one terminal of C8, the other terminal of R14 is connected to the other terminal of C8 and then is connected to A2, the positive electrode c of a direct current output loop of IC3 is a direct current output positive electrode A3, and the negative electrode d of the direct current output loop of IC3 is a direct current output earth pole V0;
the voltage-regulator divider circuit A02 comprises a regulator diode VD6, a regulator diode component VDi formed by connection in series of at least one regulator diode VD3, a capacitor C6 and a capacitor C7, the negative electrode of VDi is connected to the negative electrode of C6 and then is connected to A3, a public direct current power supply node VCC is formed by the connection of the positive electrode of VDi, the negative electrode of VD6 and the positive electrode of C7, and the positive electrode of VD6 is connected to the negative electrode of C6, the negative electrode of C7 and V0; and
the non-isolated varying-voltage circuit A03 comprises a resistor R9 and a resistor RIO, one terminal of R9 is connected to AL, the other terminal of R9 is connected to A1, one terminal of RIO is connected to AN, and the other terminal of RIO is connected to A2.

7. The control circuit of the timing relay according to claim 2, **characterized in that**: both the voltage stabilizing values of the regulator diode VD1 and the regulator diode VD2 are 24V, both the resistance values of the resistor R1 and the resistor R2 are 100kΩ, the model of the field-effect transistor Q1 is FR420, and a predetermined leakage current threshold is 100mA.

8. The control circuit of the timing relay according to claim 1, **characterized in that**: the voltage of the direct current output positive electrode A3 with respect to the direct current output earth pole V0 is any value between 20V and 100V, and the voltage of the public direct current power supply node VCC with respect to the direct current output earth pole V0 is any value between 1.5V and 15V.

## Patentansprüche

1. Steuerschaltung eines Zeitrelais, worin die Steuerschaltung eine Zeit-/Zeitverzögerungsschaltung D, eine Relaisausgangsschaltung F, der einen ersten Anschluss J1 und einen zweiten Anschluss J2 aufweist, und eine Abwärtsgleichrichter-Regelschaltung A umfasst, worin die Zeit-/Zeitverzögerungsschaltung D benutzt wird, um die Zeitverzögerungssteuerungsfunktion des Zeitrelais zu implementieren, die Abwärtsgleichrichter-Regelschaltung A benutzt wird, um das GS-WS-Umwandeln zu implementieren und einen Gleichstrom-Leistungsversorgungsknoten VCC bereitzustellen, worin die Zeit-/Zeitverzögerungsschaltung D einen Zeitverzögerungssteuerungsschaltungschip IC2 umfasst, der mit einem Auslösesteuerungssignaleingangsknoten (control) und mit einem Steuerungsausgangsknoten (out) versehen ist, und der Steuerungsausgangsknoten (out) der Zeit-/Zeitverzögerungsschaltung D mit einem Steuerungseingangsanschluss der Relaisausgangsschaltung F verbunden ist, wobei der erste Anschluss J1 und der zweite Anschluss J2 der Relaisausgangsschaltung F dafür ausgelegt sind, mit einem Steuerschalter oder mit einer Auslösevorrichtung in einer gesteuerten Lastschaltung oder in einer Laststeuerschaltung verbunden zu werden, um das Ein/Aus der Lastschaltung direkt zu steuern; worin
die Abwärtsgleichrichter-Regelschaltung A eine Gleichrichtungsschaltung A01, eine Spannungsregler-Teilerschaltung A02 und eine nicht-isolierte veränderliche Spannungsschaltung A03 umfasst, worin ein Leitungsdrahtanschluss L einer Wechselstromleistungsversorgung mit einem Wechselstromleitungsdrahteingangsknoten AL der nicht-isolierten veränderlichen Spannungsschaltung A03 verbunden ist, ein Erdungsanschluss N der Wechselstromleistungsversorgung mit einem Wechselstromerdungseingangsknoten AN der nicht-isolierten veränderlichen Spannungsschaltung A03 verbunden ist, ein Leitungsdrahtausgangsknoten A1 der nicht-isolierten veränderlichen Spannungsschaltung A03 und ein Erdungsausgangsknoten A2 der nicht-isolierten veränderlichen Spannungsschaltung A03 jeweils mit den zwei Anschlüssen einer Wechselstromeingangsschleife der Gleichrichtungsschaltung A01 verbunden sind, und die Spannungsregler-Teilerschaltung A02 parallel zwischen der Gleichstromausgangspositivelektrode A3 der Gleichrichtungsschaltung A01 und dem Gleichstromausgangserdungspol V0 der Gleichrichtungsschaltung A01 verbunden ist, so dass ein öffentlicher Gleichstromversorgungsknoten VCC gebildet wird;
die Steuerschaltung ferner eine Leckauslöseschaltung E und eine Auslösesignalverarbeitungsschaltung B umfasst, worin die Leckauslöseschaltung E einen Auslöseschalter S1, einen Knoten E1, der durch die Verbindung eines Anschlusses des Auslöseschalters S1 und eines Anschlusses eines schwachen Durchlasszustandselementes Y gebildet ist, oder einen Knoten E1, der durch die Verbindung eines Anschlusses des Auslöseschalters S1, eines Anschlusses des schwachen Durchlasszustandselementes Y und eines äußeren Auslöseanschlusses X gebildet ist, umfasst; wobei der Knoten E1 mit einem Eingangsknoten B1 der Auslösesignalverarbeitungsschaltung B verbunden ist; und ein Knoten E2 durch die Verbindung des anderen Anschlusses des Auslöseschalters S1 und des anderen Anschlusses des schwachen Durchlasszustandselementes Y gebildet ist, wobei der Knoten E2 mit irgendeinem von dem Leitungsdrahtanschluss L oder dem Erdungsanschluss N an einer Wechselstromeingangsseite der Abwärtsgleichrichter-Regelschaltung A verbunden ist, wobei die Leckauslöseschaltung E in die Auslösesignalverarbeitungsschaltung B einen Strom I über den Knoten E1 und den Eingangsknoten B1 eingibt;
worin das schwache Durchlasszustandselement ein Element ist, das einen Durchlassstrom niedriger als 100 mA, wie eine Kontrolllampe, hat;
worin der äußere Auslöseanschluss X für den Zugang einer fernen äußeren Auslösevorrichtung bestimmt ist, ein Stromsignal von der fernen äußeren Auslösevorrichtung der Schaltung B über den äußeren Auslöseanschluss X geliefert wird;
ferner worin der Strom I der Strom, der vom schwachen Durchlasszustandselement Y ausgegeben wird, oder der Strom, der vom schwachen Durchlasszustandselement Y ausgegeben wird, plus der Strom, der vom Schalter S1 ausgegeben wird, oder der Strom, der vom schwachen Durchlasszustandselement Y ausgegeben wird, plus der Strom, der von dem äußeren Auslöseanschluss X ausgegeben wird, oder der Strom, der vom schwachen Durchlasszustandselement Y ausgegeben wird, plus der Strom, der von dem äußeren Auslöseanschluss X ausgegeben wird, plus der Strom, der vom Schalter S1 ausgegeben wird, ist;
und ferner worin die Auslösesignalverarbeitungsschaltung B sich auf einen Leckstrom bezieht, der als die Leckstromschwelle genommen wird; die Leckstromschwelle benutzt wird, um mit dem Strom I verglichen zu werden, so dass das zahlenmäßige Größenverhältnis des Stroms I und der Leckstromschwelle bestimmt wird;
die Auslösesignalverarbeitungsschaltung B Reglerdioden VD1 und VD2, Dioden D2, D5 und D6, einen photoelektrischen Koppler IC1, einen Feldeffekttransistor Q1, eine Triode Q2, Widerstände R1 und R2 umfasst; die negative Elektrode der Reglerdiode VD1 und die Senke D des Feldeffekttransistors Q1 mit dem Auslösesignaleingangsknoten B1 verbunden sind, die positive Elektrode der Reglerdiode VD1 mit der positiven Elektrode des Eingangsanschlusses des photoelektrischen Kopplers IC1 über den Widerstand R1 verbunden ist, die negative Elektrode des Eingangsanschlusses des photoelektrischen Kopplers IC1 mit der Basis der Triode Q2 und dem einen Anschluss des Widerstands R2 verbunden ist, der andere Anschluss des Widerstands R2 mit dem Knoten A1 über die Diode D6, mit dem Knoten A2 über die Diode D5 und mit dem Emitter der Triode Q2 verbunden ist, die Quelle S des Feldeffekttransistors Q1 mit dem Kollektor der Triode Q2 über die Diode D2, mit dem Emitter der Triode Q1, mit dem Knoten A1 über die Diode D6, mit dem Knoten A2 über die Diode D5 und mit der negativen Elektrode der Reglerdiode VD1 verbunden ist, die positive Elektrode der Reglerdiode VD2 mit dem Emitter der Triode Q2 verbunden ist, der Kollektor der Triode Q2 mit dem Knoten A3 und mit dem Gate G des Feldeffekttransistors Q1 verbunden ist, die positive Elektrode des Ausgangsanschlusses des photoelektrischen Kopplers IC1 mit dem Knoten VCC verbunden ist, die negative Elektrode des Ausgangsanschlusses des photoelektrischen Kopplers IC1 mit dem Auslösesteuerungssignaleingangsknoten (control) verbunden ist;
die Leckauslöseschaltung E der Auslösesignalverarbeitungsschaltung B den Strom I liefert; wenn der Strom I eine Leckstromschwelle nicht übersteigt, die Senke D und die Quelle S des Feldeffekttransistors Q1 eingeschaltet sind und die Reglerdiode VD1 nicht eingeschaltet ist, das Zeitrelais nicht ausgelöst werden wird; wenn der Strom I größer als die Leckstromschwelle ist, die Senke D und die Quelle S des Feldeffekttransistors Q1 nicht eingeschaltet sind und die Reglerdiode VD1 eingeschaltet ist, dann löst die Auslösesignalverarbeitungsschaltung B die Zeit-/Zeitverzögerungsschaltung D über den Auslösesteuerungssignaleingangsknoten (control) aus, und dann steuert die Zeit-/Zeitverzögerungsschaltung D die Relaisausgangsschaltung F, um das Ein-Aus-Zustands-Umwandeln einer Last über den Steuerungsausgangsknoten (out) zu implementieren, und das Zeitrelais ausgelöst werden wird.

2. Steuerschaltung des Zeitrelais nach Anspruch 1, **dadurch gekennzeichnet, dass**: die Auslösesignalverarbeitungsschaltung B ferner Dioden D1 und D7, Widerstände R3 - R5, einen Widerstand R11 und Kondensatoren C1-C3 umfasst, worin die negative Elektrode der Diode D1 mit dem Knoten B1 verbunden ist, die positive Elektrode des Ausgangsanschlusses des photoelektrischen Kopplers IC1 mit dem VCC verbunden ist, die negative Elektrode des Ausgangsanschlusses des photoelektrischen Kopplers IC1, der eine Anschluss von R5 und der eine Anschluss von C3 mit dem Auslösesteuerungssignaleingangsknoten (control) verbunden sind, der andere Anschluss von R5 und der andere Anschluss von C3 mit V0 verbunden sind, die Quelle S des Feldeffekttransistors Q1 mit einem Anschluss von R3, der positiven Elektrode von D2 und einem Anschluss von C2 verbunden ist, das Gate G des Feldeffekttransistors Q1 mit einem Anschluss von C1, der negativen Elektrode der Reglerdiode VD2, der negativen Elektrode von D2, dem anderen Anschluss von C2 und einem Anschluss von R4 verbunden ist, der andere Anschluss von R4 mit dem Kollektor der Triode Q2 und einem Anschluss von R11 verbunden ist, der andere Anschluss von R11 mit der negativen Elektrode von D7 verbunden ist, die positive Elektrode von D7 mit A3 verbunden ist, der Emitter der Triode Q2 mit dem anderen Anschluss von R3, dem anderen Anschluss von C1, der positiven Elektrode von D6, der positiven Elektrode von D5 und der positiven Elektrode von D1 verbunden ist, die negative Elektrode von D5 mit A2 verbunden ist, und die negative Elektrode von D6 mit A1 verbunden ist.

3. Steuerschaltung des Zeitrelais nach Anspruch 1, **dadurch gekennzeichnet, dass**: die Relaisausgangsschaltung F eine Triode Q3, eine Triode Q4, eine Diode D8, einen Widerstand R12, einen Widerstand R13, einen Widerstand R15, einen Widerstand R16, ein Relais J und einen Umschalter S2 umfasst, der Emitter von Q3 mit einem Anschluss von R12 verbunden ist und dann mit A3 verbunden ist, die Basis von Q3 mit dem anderen Anschluss von R12 und einem Anschluss von R13 verbunden ist, der andere Anschluss von R13 mit einem beweglichen Kontakt von S2 verbunden ist, ein feststehender Kontakt von S2 mit dem Kollektor von Q4 verbunden ist, der andere feststehende Kontakt von S2 mit V0 verbunden ist, die Basis von Q4 mit einem Anschluss von R15 und einem Anschluss von R16 verbunden ist, der Emitter von Q4 mit dem anderen Anschluss von R15 verbunden ist und dann mit V0 verbunden ist, der andere Anschluss von R16 mit out verbunden ist, der Kollektor von Q3 mit der negativen Elektrode von D8 und mit einem Anschluss einer Eingangsschleife des Relais J verbunden ist, der andere Anschluss der Eingangsschleife des Relais J mit der positiven Elektrode von D8 verbunden ist und dann mit VCC verbunden ist, und die zwei Anschlüsse einer Kontaktschleife K1 des Relais J jeweils mit dem ersten Anschluss J1 und mit dem zweiten Anschluss J2 verbunden sind.

4. Steuerschaltung des Zeitrelais nach Anspruch 1, **dadurch gekennzeichnet, dass**: die Relaisausgangsschaltung F eine Triode Q3, eine Triode Q4, eine Diode D8, einen Widerstand R12, einen Widerstand R13, einen Widerstand R15, einen Widerstand R16, ein Relais J und einen Umschalter S2 umfasst, der Emitter von Q3 mit einem Anschluss von R12 verbunden ist und dann mit A3 verbunden ist, die Basis von Q3 mit dem anderen Anschluss von R12 und einem Anschluss von R13 verbunden ist, der andere Anschluss von R13 mit dem Kollektor von Q4 verbunden ist, die Basis von Q4 mit einem Anschluss von R15 und einem Anschluss von R16 verbunden ist, der Emitter von Q4 mit dem anderen Anschluss von R15 verbunden ist und dann mit V0 verbunden ist, der andere Anschluss von R16 mit out verbunden ist, der Kollektor von Q3 mit der negativen Elektrode von D8 und mit einem Anschluss einer Eingangsschleife des Relais J verbunden ist, der andere Anschluss der Eingangsschleife des Relais J mit der positiven Elektrode von D8 verbunden ist und dann mit VCC verbunden ist, und die zwei Anschlüsse einer Kontaktschleife K1 des Relais J jeweils mit dem ersten Anschluss J1 und mit dem zweiten Anschluss J2 verbunden sind.

5. Steuerschaltung des Zeitrelais nach Anspruch 1, **dadurch gekennzeichnet, dass**: die Zeit-/Zeitverzögerungsschaltung D eine Diode D3, eine Diode D4, einen Widerstand R6, einen Widerstand R7, einen Potentiometer R8, einen Kondensator C4 und einen Kondensator C5 umfasst, der Pin 1 von IC2 mit VCC verbunden ist, der Pin 4 von IC2 mit der positiven Elektrode von D3, einem Anschluss von R6 und einem Anschluss von C5 verbunden ist, die negative Elektrode von D3 mit dem anderen Anschluss von R6 verbunden ist und dann mit VCC verbunden ist, der andere Anschluss von C5 mit V0 verbunden ist, der Pin 5 von IC2 mit control verbunden ist, der Pin 6 von IC2 mit out verbunden ist, der Pin 7 und der Pin 8, der Pin 9 und der Pin 14 von IC2 verbunden sind und dann mit V0 verbunden sind, der Pin 11 von IC2 mit einem Anschluss von R7 verbunden ist, und der andere Anschluss von R7 mit der positiven Elektrode von D4, einem Anschluss von C4 und dem gleitenden Anschluss von R8 verbunden ist, die negative Elektrode von D4 mit dem einen feststehenden Anschluss von R8 verbunden ist und dann mit VCC verbunden ist, und der andere feststehende Anschluss von R8 mit V0 verbunden ist.

6. Steuerschaltung des Zeitrelais nach Anspruch 1, **dadurch gekennzeichnet, dass**: die Gleichrichtungsschaltung A01 eine Gleichrichterbrücke IC3, einen Widerstand R14 und einen Kondensator C8 umfasst, der Anschluss a einer Wechselstromeingangsschleife von IC3 mit A1 verbunden ist, der andere Anschluss b der Wechselstromeingangsschleife von IC3 mit einem Anschluss von R14 und einem Anschluss von C8 verbunden ist, der andere Anschluss von R14 mit dem anderen Anschluss von C8 verbunden ist und dann mit A2 verbunden ist, die positive Elektrode c einer Gleichstromausgangsschleife von IC3 eine Gleichstromausgangpositivelektrode A3 ist, und die negative Elektrode d der Gleichstromausgangsschleife von IC3 ein Gleichstromausgangserdungspol V0 ist;
die Spannungsregler-Teilerschaltung A02 eine Reglerdiode VD6 umfasst, wobei ein Reglerdiodenbauteil VDi durch Verbindung der Reihe nach von zumindest einer Reglerdiode VD3, einem Kondensator C6 und einem Kondensator C7 gebildet ist, die negative Elektrode von VDi mit der negativen Elektrode von C6 verbunden ist und dann mit A3 verbunden ist, ein öffentlicher Gleichstromversorgungsknoten VCC durch die Verbindung der positiven Elektrode von VDi, der negativen Elektrode von VD6 und der positiven Elektrode von C7 gebildet ist, und die positive Elektrode von VD6 mit der negativen Elektrode von C6, der negativen Elektrode von C7 und V0 verbunden ist; und
die nicht-isolierte veränderliche Spannungsschaltung A03 einen Widerstand R9 und einen Widerstand R10 umfasst, ein Anschluss von R9 mit AL verbunden ist, der andere Anschluss von R9 mit A1 verbunden ist, ein Anschluss von R10 mit AN verbunden ist, und der andere Anschluss von R10 mit A2 verbunden ist.

7. Steuerschaltung des Zeitrelais nach Anspruch 2, **dadurch gekennzeichnet, dass**: sowohl die Spannungsstabilisierungswerte der Reglerdiode VD1 und der Reglerdiode VD2 24V betragen, sowohl die Widerstandswerte des Widerstands R1 und des Widerstands R2 10kΩ betragen, das Modell des Feldeffekttransistors Q1 FR420 ist, und eine vorgegebene Leckstromschwelle 100mA ist.

8. Steuerschaltung des Zeitrelais nach Anspruch 1, **dadurch gekennzeichnet, dass**: die Spannung der Gleichstromausgangspositivelektrode A3 mit Bezug auf den Gleichstromausgangserdungspol V0 jeglichen Wert zwischen 20V und 100V beträgt, und die Spannung des öffentlichen Gleichstromversorgungsknotens VCC mit Bezug auf den Gleichstromausgangserdungspol V0 jeglichen Wert zwischen 1,5V und 15V beträgt.

## Revendications

1. Un circuit de commande d'un relai temporel, ce circuit de commande comprenant un circuit de minutage/temporisation D, un circuit de sortie de relais F ayant une première borne J1 et une deuxième borne J2, et un circuit de régulation redresseur dégressif A, le circuit de minutage/temporisation D étant utilisé pour mettre en œuvre la fonction de commande de temporisation du relais temporel, le circuit de régulation redresseur dégressif A étant utilisé pour mettre en œuvre une conversion courant alternatif/continu et fournir un nœud d'alimentation en courant continu VCC, le circuit de minutage/temporisation D comprenant une puce de circuit de commande de temporisation IC2 pourvue d'un nœud d'entrée de signal de commande de déclenchement (commande) et d'un nœud de sortie de commande (sortie), et le nœud de sortie de commande (sortie) du circuit de minutage/temporisation D étant connecté à une borne d'entrée de commande du circuit de sortie de relais F, la première borne J1 et la deuxième borne J2 du circuit de sortie de relais F étant configurées pour être connectées à un interrupteur de commande ou un appareil de déclenchement dans un circuit de charge commandée ou un circuit de commande de charge, pour commander directement la mise en marche ou l'arrêt du circuit de charge ; dans lequel
le circuit de régulation redresseur dégressif A comprend un circuit redresseur A01, un circuit diviseur régulateur de tension A02 et un circuit à tension variable non isolé A03, une borne de fil sous tension L d'une alimentation en courant alternatif est connectée un nœud d'entrée de fil sous tension de courant alternatif AL du circuit à tension variable non 03, une borne de terre N de l'alimentation en courant alternatif est connectée à un nœud d'entrée de courant alternatif AN du circuit à tension variable non isolé A03, un nœud de sortie de fil sous tension A1 du circuit à tension variable non isolé A03 et un nœud de sortie de terre A2 du circuit à tension variable non isolé A03 sont respectivement connectés à deux bornes d'une boucle d'entrée de courant alternatif du circuit redresseur A01, et le circuit diviseur régulateur de tension A02 est connecté en parallèle entre l'électrode positive de sortie de courant continu A3 du circuit redresseur A01 et le pôle de terre de sortie de courant continu V0 du circuit redresseur A01, de manière à former un nœud d'alimentation en courant continu public VCC ;
le circuit de commande comprend en outre un circuit de déclenchement de fuite E et un circuit de traitement de signal de déclenchement B, le circuit de déclenchement de fuite E comprend un interrupteur de déclenchement S1, un nœud E1 formé par la connexion d'une borne de l'interrupteur de déclenchement S1 et une borne d'un élément d'état passant faible Y, ou un nœud E1 formé par la connexion d'une borne de l'interrupteur de déclenchement S1, une borne de l'élément d'état passant faible Y et une borne de déclenchement externe X ; le nœud E1 étant connecté à un nœud d'entrée B1 du circuit de traitement de signal de déclenchement B ; et un nœud E2 formé par la connexion du l'autre borne de l'interrupteur de déclenchement S1 et l'autre borne de l'élément d'état passant faible Y, le nœud E2 étant connecté à l'un ou à l'autre de la borne de fil sous tension L et de la borne de terre N d'un côté d'entrée de courant alternatif du circuit de régulation redresseur dégressif A, le circuit de déclenchement de fuite E laissant entrer un courant I vers le circuit de traitement de signal de déclenchement B à travers le nœud E1 et le nœud d'entrée B 1 ;
dans lequel l'élément d'état passant faible est une élément ayant un courant d'état passant inférieur à 100 mA tel qu'une lampe témoin ;
dans lequel la borne de déclenchement externe X est pour l'accès d'un appareil de déclenchement externe éloigné, un signal de courant est donné par l'appareil de déclenchement externe éloigné au circuit B à travers la borne de déclenchement externe X ;
dans lequel en outre le courant I est le courant fourni par l'élément d'état passant faible Y ou le courant fourni par l'élément d'état passant faible Y plus le courant fourni par l'interrupteur S1, ou le courant fourni par l'élément d'état passant faible Y plus le courant fourni par la borne de déclenchement externe X, ou le courant fourni par l'élément d'état passant faible Y plus le courant fourni par la borne de déclenchement externe X plus le courant fourni par l'interrupteur S1 ;
et dans lequel en outre le circuit de traitement de signal de déclenchement B se réfère à un courant de fuite, lequel est pris en tant que seuil de courant de fuite ; le seuil de courant de fuite est utilisé pour être comparé avec le courant I de sorte que la relation de dimension numérique du courant I et du seuil de courant de fuite soit déterminée,
le circuit de traitement de signal de déclenchement B comprend des diodes de régulation VD1 et VD2, des diodes D2, D5 et D6, et un coupleur photoélectrique IC1, un transistor à effet de champ Q1, un triac Q2, des résistances R1 et R2, l'électrode négative de la diode de régulation VD1 et le drain D du transistor à effet de champ Q1 sont connectées au nœud d'entrée de signal de déclenchement B1, l'électrode positive de la diode de régulation VD1 est connectée à l'électrode positive de la borne d'entrée du coupleur photoélectrique IC1 à travers la résistance R1, l'électrode négative de la borne d'entrée du coupleur photoélectrique ICI est connectée à la base du triac Q2 et à une borne de la résistance R2, l'autre borne de la résistance R2 est connectée au nœud A1 via la diode D6, au nœud A2 via la diode D5 et à l'émetteur du triac Q2, la source S du transistor à effet de champ Q1 est connectée au collecteur du triac Q2 via la diode D2, à l'émetteur du triac Q1, au nœud A1 via la diode D6, au nœud A2 via la diode D5 et à l'électrode négative de la diode de régulation VD1, l'électrode positive de la diode de régulation VD2 est connectée à l'émetteur du triac Q2, le collecteur du triac Q2 est connecté au nœud A3 et à la grille G du transistor à effet de champ Q1, l'électrode positive de la borne de sortie du coupleur photoélectrique IC1 est connectée au nœud VCC, l'électrode négative de la borne de sortie du coupleur photoélectrique IC1 est connectée au nœud d'entrée de signal de commande de déclenchement (commande) ;
le circuit de déclenchement de fuite E fournit le courant I au circuit de traitement de signal de déclenchement B ; lorsque le courant I n'excède pas un seuil de courant de fuite, le drain D et la source S du transistor à effet de champ Q1 sont branchés et la diode de régulation VD1 n'est pas branchée, le relais temporel ne sera pas déclenché ; lorsque le courant I est supérieur au seuil de courant de fuite, le drain D et la source S du transistor à effet de champ Q1 ne sont pas branchés et la diode de régulation VD1 est branchée, alors le circuit de traitement de signal de déclenchement B déclenche le circuit de minutage/temporisation D à travers le nœud d'entrée de signal de commande de déclenchement (commande), et ensuite le circuit de minutage/temporisation D commande le circuit de sortie de relais F pour mettre en œuvre la conversion d'état passant/bloqué d'une charge à travers le nœud de sortie de commande (sortie), et le relais temporel va être déclenché.

2. Le circuit de commande de relais temporel selon la revendication 1, **caractérisé en ce que** : le circuit de traitement de signal de déclenchement B comprend en outre des diodes D1 et D7, des résistances R3-R5, une résistance R11 et des condensateurs C1-C3, dans lequel l'électrode négative de la diode D1 est connectée au nœud B1, l'électrode positive de la borne de sortie du coupleur photoélectrique IC1 est connectée à VCC, l'électrode négative de la borne de sortie du coupleur photoélectrique IC1, une borne de R5 et une borne de C3 sont connectées au nœud d'entrée de signal de commande de déclenchement (commande), l'autre borne de R5 et l'autre borne de C3 sont connectées à V0, la source S du transistor à effet de champ Q1 est connectée à une borne de R3, à l'électrode positive de D2 et à une borne de C2, la grille G du transistor à effet de champ Q1 est connectée à une borne de C1, à l'électrode négative de la diode de régulation VD2, à l'électrode négative de D2, à l'autre borne de C2 et à une borne de R4, l'autre borne de R4 est connectée au collecteur du triac Q2 et à une borne de R11, l'autre borne de R11 est connectée à l'électrode négative de D7, l'électrode positive de D7 est connectée à A3, l'émetteur du triac Q2 est connecté à l'autre borne de R3, à l'autre borne de C1, à l'électrode positive de D6, à l'électrode positive de D5 et à l'électrode positive de D1, l'électrode négative de D5 est connectée à A2, et l'électrode négative de D6 est connectée à A1.

3. Le circuit de commande de relais temporel selon la revendication 1, **caractérisé en ce que** : le circuit de sortie de relais F comprend un triac Q3, un triac Q4, une diode D8, une résistance R12, une résistance R13, une résistance R15, une résistance R16, un relais J et un commutateur S2, l'émetteur de Q3 est connecté à une borne de R12 et est ensuite connecté à A3, la base de Q3 est connectée à l'autre borne de R12 et à une borne de R13, l'autre borne de R13 est connectée à un contact mobile de S2, un contact stationnaire de S2 est connecté au collecteur de Q4, l'autre contact stationnaire de S2 est connecté à V0, la base de Q4 est connectée à une borne de R15 et à une borne de R16, l'émetteur de Q4 est connecté à l'autre borne de R15 et est ensuite connecté à V0, l'autre borne de R16 est connectée à la sortie, le collecteur de Q3 est connecté à l'électrode négative de D8 et à une borne d'une boucle d'entrée du relais J, l'autre borne de la boucle d'entrée du relais J est connectée à l'électrode positive de D8 et est ensuite connectée à VCC, et les deux bornes d'une boucle de contact K1 du relais J sont respectivement connectées à la première borne J1 et à la deuxième borne J2.

4. Le circuit de commande de relais temporel selon la revendication 1, **caractérisé en ce que** : le circuit de sortie de relais F comprend un triac Q3, un triac Q4, une diode D8, une résistance R12, une résistance R13, une résistance R15, une résistance R16, un relais J et un commutateur S2, l'émetteur de Q3 est connecté à une borne de R12 et est ensuite connecté à A3, la base de Q3 est connectée à l'autre borne de R12 et à une borne de R13, l'autre borne de R13 est connectée au collecteur de Q4, la base de Q4 est connectée à une borne de R15 et à une borne de R16, l'émetteur de Q4 est connecté à l'autre borne de R15 et est ensuite connecté à V0, l'autre borne de R16 est connectée à la sortie, le collecteur de Q3 est connecté à l'électrode négative de D8 et à une borne d'une boucle d'entrée du relais J, l'autre borne de la boucle d'entrée du relais J est connectée à l'électrode positive de D8 et est ensuite connectée à VCC, et les deux bornes d'une boucle de contact K1 du relais J sont respectivement connectées à la première borne J2 et à la deuxième borne J2.

5. Le circuit de commande de relais temporel selon la revendication 1, **caractérisé en ce que** : le circuit de minutage/temporisation D comprend une diode D3, une diode D4, une résistance R6, une résistance R7, un potentiomètre R8, un condensateur C4 et un condensateur C5, la broche 1 de IC2 est connectée à VCC, la broche 4 de IC2 est connectée à l'électrode positive de D3, à une borne de R6 et à une borne de C5, l'électrode négative de D3 est connectée à l'autre borne de R6 et est ensuite connectée à VCC, l'autre borne de C5 est connectée à V0, la broche 5 de IC2 est connectée à la commande, la broche 6 de IC2 est connectée à la sortie, à la broche 7 et à la broche 8, la broche 9 et la broche 14 de IC2 sont connectées et sont ensuite connectées à V0, la broche 11 de IC2 est connectée à une borne de R7, et l'autre borne de R7 est connectée à l'électrode positive de D4, à une borne de C4 et au curseur de R8, l'électrode négative de D4 est connectée à une borne fixe de R8 et est ensuite connectée à VCC, et l'autre borne fixe de R8 est connectée à V0.

6. Le circuit de commande de relais temporel selon la revendication 1, **caractérisé en ce que** : le circuit redresseur A01 comprend un pont de redressement IC3, une résistance R14 et un condensateur C8, la borne d'une boucle d'entrée à courant alternatif de IC3 est connectée à A1, l'autre borne b d'une boucle d'entrée de courant alternatif de IC3 est connectée à une borne de R14 et à une borne de C8, l'autre borne de R14 est connectée à l'autre borne de C8 et est ensuite connectée à A2, l'électrode positive c d'une boucle de sortie de courant continu de IC3 est une électrode positive de sortie de courant continu A3 et l'électrode négative d de la boucle de sortie de courant continu de IC3 est un pôle de terre de sortie de courant continu V0 ;
le circuit diviseur régulateur de tension A02 comprend une diode de régulation VD6, un composant de diode de régulation VDi formé par connexion en série d'au moins une diode de régulation VD3, d'un condensateur C6 et d'un condensateur C7, l'électrode négative de VDi est connectée à l'électrode négative de C6 et est ensuite connectée à A3, un nœud d'alimentation en courant continu public VCC est formé par la connexion de l'électrode positive de VDi, de l'électrode négative de VD6 et de l'électrode positive de C7, et l'électrode positive de VD6 est connectée à l'électrode négative de C6, à l'électrode négative de C7 et à V0 ; et
le circuit de tension variable non isolé A03 comprend une résistance R9 et une résistance R10, une borne de R9 est connectée à AL, l'autre borne de R9 est connectée à A1, une borne de R10 est connectée à AN et l'autre borne de R10 est connectée à A2.

7. Le circuit de commande de relais temporel selon la revendication 2, **caractérisé en ce que** : les valeurs de stabilisation de tension de la diode de régulation VD1 ainsi que de la diode de régulation VD2 sont de 24 V, les valeurs de résistance de la résistance R1 et de la résistance R2 sont de 100 kQ, le modèle du transistor à effet de champ Q1 est FR420 et un seuil de courant de fuite est de 100 mA.

8. Le circuit de commande de relais temporel selon la revendication 1, **caractérisé en ce que** la tension de l'électrode positive de sortie de courant continu A3 par rapport au pôle de terre de sortie de courant continu V0 a toute valeur comprise entre 20 V et 100 V, et la tension du nœud d'alimentation en courant continu public VCC par rapport au pôle de terre de sortie de courant continu V0 a toute valeur comprise entre 1,5 V et 15 V.
